# EUROPEAN PATENT APPLICATION

(11) **EP 4 503 128 A2**
(43) Date of publication of application: **05.02.2025**
(21) Application number: 24190143.8
(22) Date of filing: 22.07.2024
(51) Int. Cl.: H01L 27/02, H01L 21/8234, H01L 29/78, H01L 23/485, H01L 27/118

(54) **SEMICONDUCTOR DEVICES INCLUDING GATE STRUCTURES AND IMPURITY REGIONS**

(30) Priority: 04.08.2023 KR 20230101947
(71) Applicant: Samsung Electronics Co., Ltd, Suwon-si, Gyeonggi-do 16677 (KR)
(72) Inventor: OH, Junghyun, 16677 Suwon-si (KR); KIM, Jungkyung, 16677 Suwon-si (KR)
(74) Representative: Marks & Clerk LLP

(57) **Abstract**

A semiconductor device includes a gate structure disposed on a substrate and extending along a first direction that is substantially parallel to an upper surface of the substrate, first and second impurity regions disposed on portions of the substrate at opposite sides of the gate structure along a second direction that is substantially parallel to the upper surface of the substrate, the first and second impurity regions being substantially perpendicular to each other, wherein the first and second impurity regions are each doped with n-type impurities, a third impurity region disposed on a portion of the substrate adjacent to the first impurity region along the second direction, wherein the third impurity region is doped with p-type impurities, a fourth impurity region disposed on a portion of the substrate adjacent to the first impurity region along the first direction, wherein the fourth impurity region is connected to the third impurity region and is doped with p-type impurities and a wiring structure disposed on the gate structure, wherein the wiring structure includes wirings that are disposed on a plurality of different levels. The fourth impurity region does not overlap a first one of the wirings along a vertical direction that is substantially perpendicular to the upper surface of the substrate. The first one of the wirings is disposed at an uppermost level among the plurality of different levels.

## Description

### TECHNICAL FIELD

The present disclosure relates to a semiconductor device and, more specifically, to a semiconductor device including gate structures and impurity regions.

### DISCUSSION OF THE RELATED ART

During operation of a power management integrated circuit (PMIC), overcurrent occurs due to the parasitic operation of a bipolar junction transistor (BJT) triggered by activation of a diode and ripple. This may lead to the burning of circuit patterns within the PMIC. Thus, a solution of preventing burning of the circuit patterns is needed.

### SUMMARY

Example embodiments provide a semiconductor device having improved characteristics.

According to example embodiments, there is provided a semiconductor device. The semiconductor device may include a gate structure disposed on a substrate and extending along a first direction that is substantially parallel to an upper surface of the substrate, first and second impurity regions disposed on portions of the substrate at opposite sides of the gate structure along a second direction that is substantially parallel to the upper surface of the substrate, the first and second impurity regions being substantially perpendicular to each other, wherein the first and second impurity regions are each doped with n-type impurities, a third impurity region disposed on a portion of the substrate adjacent to the first impurity region along the second direction, wherein the third impurity region is doped with p-type impurities, a fourth impurity region disposed on a portion of the substrate adjacent to the first impurity region along the first direction, wherein the fourth impurity region is connected to the third impurity region and is doped with p-type impurities and a wiring structure disposed on the gate structure, wherein the wiring structure includes wirings that are disposed on a plurality of different levels. The fourth impurity region does not overlap a first one of the wirings along a vertical direction that is substantially perpendicular to the upper surface of the substrate. The first one of the wirings is disposed at an uppermost level among the plurality of different levels.

According to example embodiments, there is provided a semiconductor device. The semiconductor device may include a gate structure disposed on a substrate, wherein the gate structure extends along a first direction substantially parallel to an upper surface of the substrate, first and second impurity regions disposed on portions of the substrate at opposite sides of the gate structure along a second direction substantially parallel to the upper surface of the substrate, and the first and second impurity regions being substantially perpendicular to each other and a wiring structure disposed on the gate structure, wherein the wiring structure includes wirings at a plurality of different levels. The gate structure includes a protrusion portion that protrudes along the second direction from a sidewall of the gate structure along the second direction. The protrusion portion of the gate structure does not overlap a first one of the wirings along a vertical direction substantially perpendicular to the upper surface of the substrate. The first one of the wirings are disposed at an uppermost level among the plurality of different levels.

According to example embodiments, there is provided a semiconductor device. The semiconductor device may include gate structures disposed on a substrate, wherein each of the gate structures extends along a first direction substantially parallel to an upper surface of the substrate, and wherein the gate structures are spaced apart from each other along a second direction substantially parallel to the upper surface of the substrate and substantially perpendicular to the first direction, first and second impurity regions disposed on opposite portions of the substrate with respect to the gate structure, wherein each of the first and second impurity regions extends along the first direction and is doped with n-type impurities, a third impurity region extending through the first impurity region to divide the first impurity region into two parts along the second direction, wherein the third impurity region is doped with p-type impurities, a fourth impurity region extending through the first impurity region along the first direction, wherein the fourth impurity region is connected to the third impurity region and is doped with p-type impurities, a first metal silicide pattern disposed on the first, third and fourth impurity regions, a second metal silicide pattern disposed on the second impurity region and a wiring structure disposed on the first and second metal silicide patterns, wherein the wiring structure includes wirings at a plurality of different levels and is electrically connected to the first and second metal silicide patterns. The fourth impurity region does not overlap a first one of the wirings along a vertical direction substantially perpendicular to the upper surface of the substrate. The first one of the wirings is disposed at an uppermost level among the plurality of different levels.

At least some of the above and other features of the invention are set out in the claims.

### BRIEF DESCRIPTION OF THE DRAWINGS

A more complete appreciation of the present disclosure and many of the attendant aspects thereof will be readily obtained as the same becomes better understood by reference to the following detailed description when considered in connection with the accompanying drawings, wherein:
FIG. 1 is a plan view illustrating a semiconductor device in accordance with example embodiments;
FIG. 2 is an enlarged plan view of region X of FIG. 1;
FIG. 3 is a set of cross-sectional views taken along lines A-A' and B-B', respectively, of FIG. 2;
FIG. 4 is a cross-sectional view taken along line C-C' of FIG. 2;
FIGS. 5 and 6 are plan views illustrating a relatively position between the transistor and an upper wiring;
FIGS. 7 and 8 are graphs showing drain currents in the transistor;
FIG. 9 is a simulation picture illustrating stress applied to the second channel included in the second transistor according to the relative position between the second transistor and the upper wiring;
FIG. 10 shows a graph illustrating ON BVs of a transistor in Comparative Embodiment and a transistor in Example Embodiment;
FIGS. 11, 12, 13, 14 and 15 are plan views and cross-sectional views illustrating a method of manufacturing a semiconductor device in accordance with example embodiments; and
FIGS. 16 and 17 are a plan view and a cross-sectional view illustrating a semiconductor device in accordance with example embodiments.

### DETAILED DESCRIPTION OF EXAMPLE EMBODIMENTS

The above and other aspects and features of a semiconductor device and a method of manufacturing the same in accordance with example embodiments will become readily understood from detail descriptions that follow, with reference to the accompanying drawings. It will be understood that, although the terms "first," "second," and/or "third" may be used herein to describe various materials, layers (films), regions, electrodes, pads, patterns, structures and processes, these materials, layers (films), regions, electrodes, pads, patterns, structures and processes should not necessarily be limited by these terms. These terms are used to distinguish one material, layer (film), region, electrode, pad, pattern, structure and process from another material, layer (film), region, electrode, pad, pattern, structure and process. Thus, a first material, layer (film), region, electrode, pad, pattern, structure and process discussed below could be termed a second or third material, layer (film), region, electrode, pad, pattern, structure and process without departing from the teachings of inventive concepts.

Hereinafter, in the specification, two directions that are substantially perpendicular to each other among horizontal directions, which are substantially parallel to an upper surface of a substrate, may be referred to as first and second directions D1 and D2, respectively, and two directions among the horizontal directions that are substantially perpendicular to each other and have an acute angle with respect to the first and second directions D1 and D2 may be referred to as third and fourth directions D3 and D4, respectively. Additionally, a vertical direction substantially perpendicular to the upper surface of the substrate may be referred to as a fifth direction D5. Whilst the terms "horizontal" and "vertical" are used herein, it will be appreciated that these terms are relative to the structure of the device, and do not imply any particular orientation of the device in use.

Each of the first to fifth directions D1, D2, D3, D4 and D5 may represent not only a direction shown in the drawing, but also an inverse direction to the shown direction. Accordingly, a direction that is acute to D1 and D2 may be acute relative to D1 or a direction opposite to D1, and may be acute to D2 or a direction opposite to D2. That is, the third and fourth direction D3 and D4 may be directions that are parallel to the horizontal direction, but different (non-parallel) to D1 and D2 and different to each other.

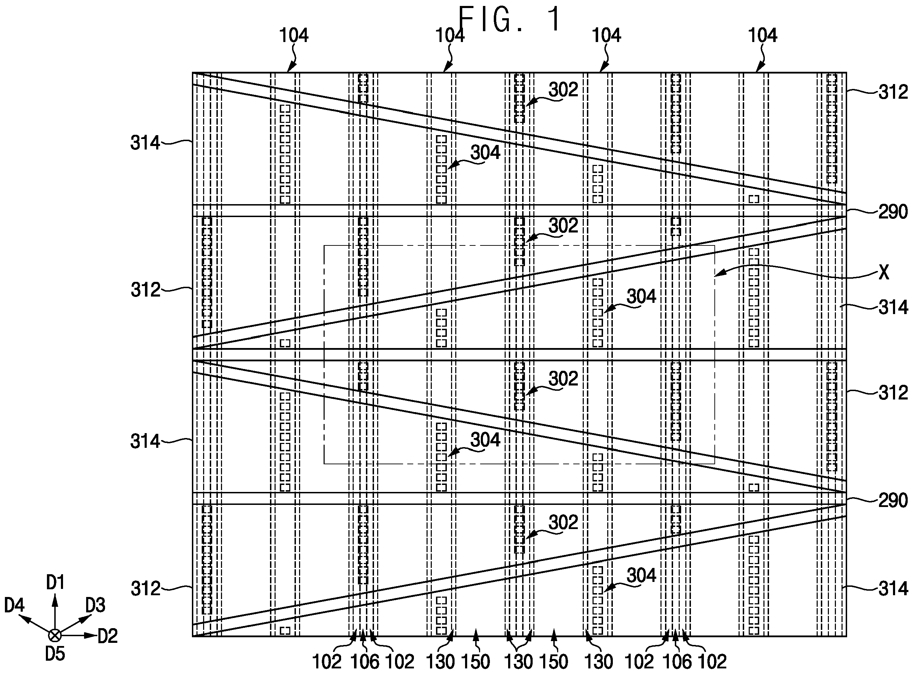

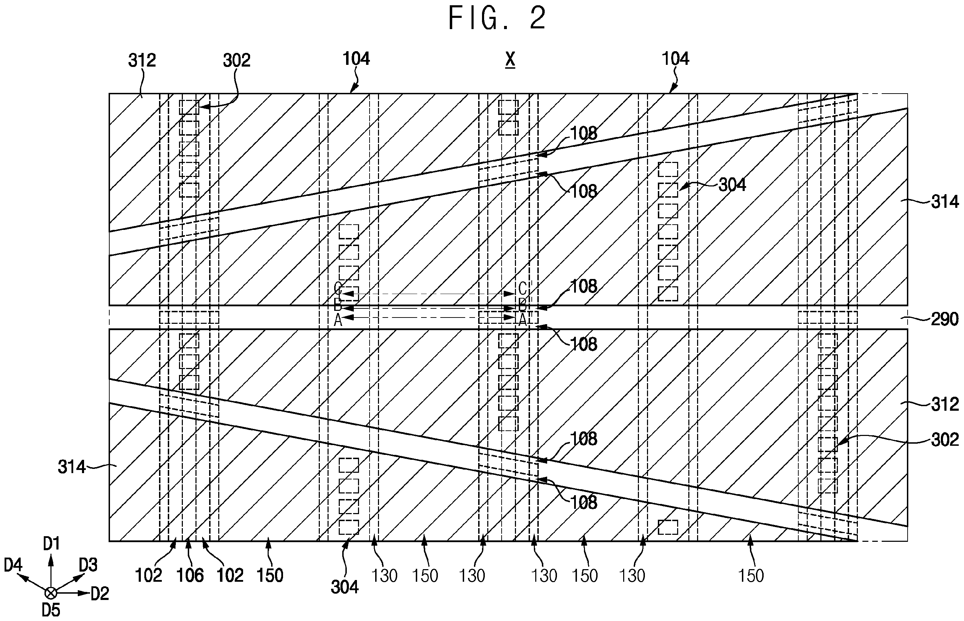

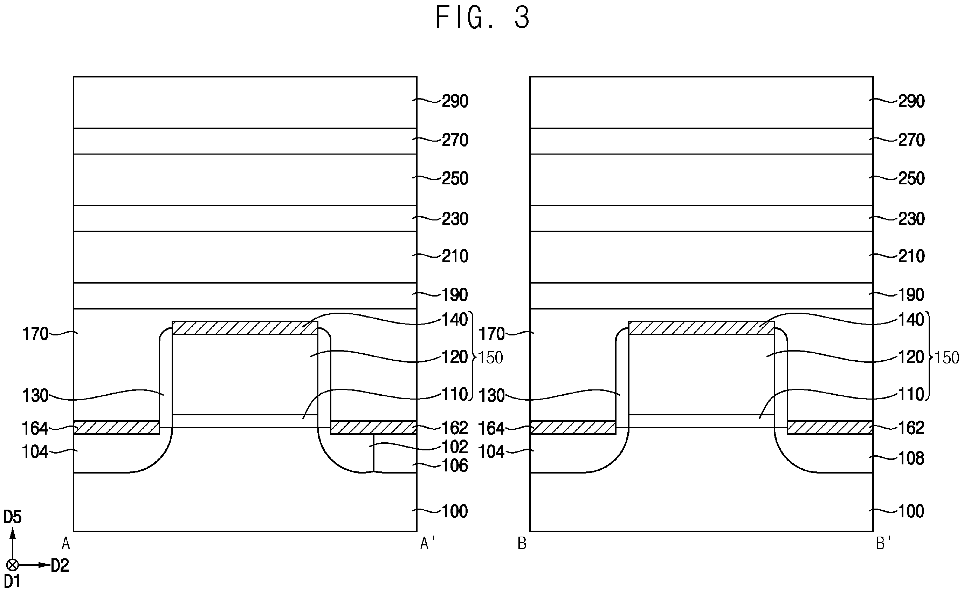

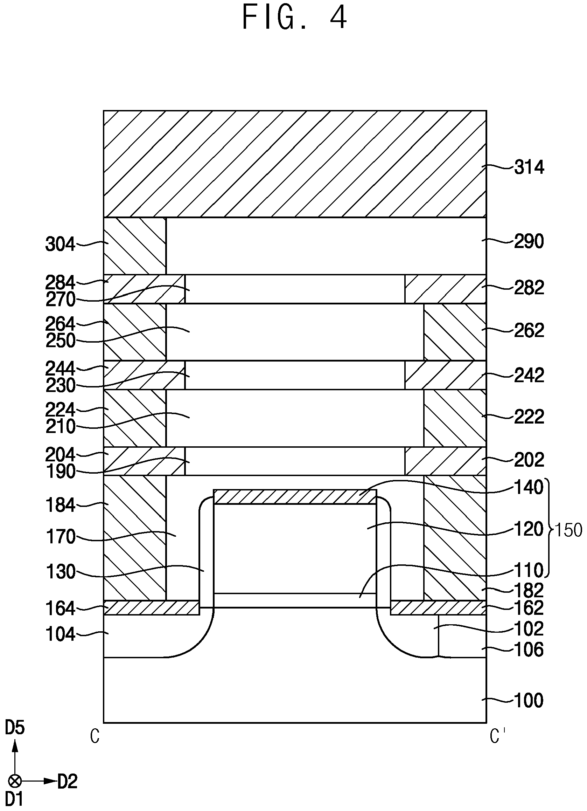

FIGS. 1 and 2 are plan views illustrating a semiconductor device in accordance with example embodiments, FIG. 3 includes cross-sectional views taken along lines A-A' and B-B', respectively, of FIG. 2, and FIG. 4 is a cross-sectional view taken along line C-C' of FIG. 2. FIG. 2 is an enlarged plan view of region X of FIG. 1.

Referring to FIGS. 1 to 4, the semiconductor device may include a gate structure 150 disposed on a substrate 100, first to fourth impurity regions 102, 104, 106 and 108, and a wiring structure.

The semiconductor device may further include a gate spacer 130, second and third metal silicide patterns 162 and 164, first and second contact plugs 182 and 184, and first to seventh insulating interlayers 170, 190, 210, 230, 250, 270 and 290.

The wiring structure may include first to sixth vias 222, 224, 262, 264, 302 and 304, and first to eighth wirings 202, 204, 242, 244, 282, 284, 312 and 314.

The substrate 100 may include a semiconductor material such as silicon, germanium, silicon-germanium, etc., or a III-V group compound semiconductor such as Gallium Phosphide (GaP), Gallium Arsenide (GaAs), Gallium Antimonide (GaSb), etc. In example embodiments, the substrate 100 may be a silicon-on-insulator (SOI) substrate or a germanium-on-insulator (GOI) substrate. In example embodiments, a p-type well doped with p-type impurities may be formed in the substrate 100.

The gate structure 150 may include a gate insulation pattern 110, a gate electrode 120 and a first metal silicide pattern 140 sequentially stacked on the substrate 100 in the fifth direction D5.

The gate insulation pattern 110 may include an oxide, e.g., silicon oxide, the gate electrode 120 may include polysilicon doped with n-type or p-type impurities, and the first metal silicide pattern 140 may include, e.g., titanium silicide, nickel silicide, cobalt silicide, etc.

Alternatively, the gate electrode 120 may include elements such as a metal, a metal nitride, a metal silicide, etc., and in this case, a gate mask including an insulating nitride. For example, silicon nitride may be formed on the gate electrode 120, instead of the first metal silicide pattern 140.

In example embodiments of the present invention, the gate structure 150 may extend along the first direction D1, and a plurality of gate structures 150 may be spaced apart from each other along the second direction D2.

The gate spacer 130 may be formed on each of opposite sidewalls of the gate structure 150 along the second direction D2. In an example embodiment of the present invention, an uppermost surface of the gate spacer 130 may be disposed at a lower level than an upper surface of the first metal silicide pattern 140, however, the inventive concept may not necessarily be limited thereto.

In an example embodiment of the present invention, the gate spacer 130 may include an insulating nitride such as silicon nitride. In some embodiments, the gate spacer 130 may have a stacked structure including a first spacer containing an oxide such as silicon oxide and a second spacer containing an insulating nitride such as silicon nitride.

Each of the first and second impurity regions 102 and 104 may extend along the first direction D1 and may be disposed on a portion of the substrate 100 between neighboring gate structures 150 along the second direction D2. In example embodiments of the present invention, the first and second impurity regions 102 and 104 may be alternatively disposed along the second direction D2.

However, in example embodiments of the present invention, the third impurity region 106 may extend through the first impurity region 102 along the first direction D1. For example, the third impurity region 106 may penetrate the first impurity region 102. Thus, the first impurity region 102 may be divided into two parts by the third impurity region 106 between neighboring ones of the gate electrodes 120 along the second direction D2.

In example embodiments of the present invention, the fourth impurity region 108 may extend through the first impurity region 102 in one of the second to fourth directions D2, D3 and D4 and may be disposed on the portion of the substrate 100 between neighboring ones of the gate electrodes 120 along the second direction D2. A plurality of fourth impurity regions 108 may be spaced apart from each other along the first direction D1.

Two fourth impurity regions 108, which are adjacent to each other along the first direction D1 and extend in the same direction may form an impurity region pair. A plurality of impurity region pairs may be spaced apart from each other along the first direction D1.

In example embodiments of the present invention, the impurity region pair may include a first impurity region pair, a second impurity region pair and a third impurity region pair. The first impurity region pair may include two of the fourth impurity regions 108, each of which may extend along the second direction D2. A plurality of first impurity region pairs may be spaced apart from each other along the first direction D1. The second impurity region pair may include two of the fourth impurity regions 108, each of which may extend along the third direction D3, and the third impurity region pair may include two the fourth impurity regions 108, each of which may extend along the fourth direction D4. In example embodiments of the present invention, each of the second and third impurity region pairs may be disposed between two adjacent first impurity region pairs, and the second and third impurity region pairs may be alternatively disposed along the first direction D1.

Thus, the first impurity region pair, the second impurity region pair, the first impurity region pair and the third impurity region pair may be disposed along the first direction D1 in this order on the portion of the substrate 100 between neighboring gate electrodes 120 along the second direction D2.

Each of the fourth impurity regions 108 may be connected to the third impurity region 106 and may extend along one of the second to fourth directions D2, D3 and D4.

In example embodiments of the present invention, each of the first and second impurity regions 102 and 104 may include n-type impurities such as phosphorus, arsenic, etc., and each of the third and fourth impurity regions 106 and 108 may include p-type impurities such as boron, aluminum, etc.

The first and second impurity regions 102 and 104 may also be referred to as first and second source/drain regions 102 and 104, respectively. For example, the gate structure 150 and the first and second source/drain regions 102 and 104 may form a transistor. A source/drain region may be a region that may serve as a source or a drain, depending on the arrangement of the transistor. For example, the first and second source/drain regions 102 and 104 may serve as a source and a drain, respectively, of the transistor.

The second metal silicide pattern 162 may be formed on the first source/drain region 102 and the third and fourth impurity regions 106 and 108, and the third metal silicide pattern 164 may be formed on the second source/drain region 104. Each of the second and third metal silicide patterns 162 and 164 may include a metal silicide such as titanium silicide, nickel silicide, cobalt silicide, etc.

The first insulating interlayer 170 may be formed on the substrate 100, and may at least partially cover the gate structure 150, the gate spacer 130 and the second and third metal silicide patterns 162 and 164, and the first and second contact plugs 182 and 184 which may extend through the first insulating interlayer 170 and contact upper surfaces of the first and second source/drain regions 102 and 104, respectively. As used herein, the phrase "at least partially covering" may mean that the first element covers some or all of the second element.

In example embodiments of the present invention, a plurality of first contact plugs 182 may be spaced apart from each other along the first direction D1 and may be disposed on the second metal silicide pattern 162 extending along the first direction D1. A plurality of second contact plugs 184 may be spaced apart from each other along the first direction D1 and may be disposed on the third metal silicide pattern 164 extending along the first direction D1.

The second to seventh insulating interlayers 190, 210, 230, 250, 270 and 290 may be sequentially stacked on the first insulating interlayer 170 and the first and second contact plugs 182 and 184. Each of the first to seventh insulating interlayers 170, 190, 210, 230, 250, 270 and 290 may include an oxide such as silicon oxide or a low-k dielectric material. As used herein, the term "low-k" may be understood to mean a material having a dielectric constant that is less than that of silicon oxide.

The first and second wirings 202 and 204 may extend through the second insulating interlayer 190 and contact upper surfaces of the first and second contact plugs 182 and 184, respectively. Each of the first and second wirings 202 and 204 may extend along the first direction D1 to a predetermined length. In an example embodiment of the present invention, a plurality of first wirings 202 may be spaced apart from each other in the first direction D 1, and a plurality of second wirings 204 may be spaced apart from each other along the first direction D1.

The first and second vias 222 and 224 may extend through the third insulating interlayer 210 and contact upper surfaces of the first and second wirings 202 and 204, respectively. In example embodiments of the present invention, a plurality of first vias 222 may be spaced apart from each other along the first direction D1 and may be disposed on the first wiring 202 extending in the first direction D1. A plurality of second vias 224 may be spaced apart from each other along the first direction D1 and may be disposed on the second wiring 204 extending in the first direction D1.

The third and fourth wirings 242 and 244 may extend through the fourth insulating interlayer 230 and contact upper surfaces of the first and second vias 222 and 224, respectively. In example embodiments of the present invention, each of the third and fourth wirings 242 and 244 may extend along the first direction D1 to a predetermined length. In an example embodiment of the present invention, a plurality of third wirings 242 may be spaced apart from each other along the first direction D1, and a plurality of fourth wirings 244 may be spaced apart from each other along the first direction D1.

The third and fourth vias 262 and 264 may extend through the fifth insulating interlayer 250 and contact upper surfaces of the third and fourth wirings 242 and 244, respectively. In example embodiments of the present invention, a plurality of third vias 262 may be spaced apart from each other along the first direction D1 and may be disposed on the third wiring 242 extending in the first direction D1. A plurality of fourth vias 264 may be spaced apart from each other in the first direction D1 and may be disposed on the fourth wiring 244 extending along the first direction D1.

The fifth and sixth wirings 282 and 284 may extend through the sixth insulating interlayer 270 and contact upper surfaces of the third and fourth vias 262 and 264, respectively. In example embodiments of the present invention, each of the fifth and sixth wirings 282 and 284 may extend along the first direction D1 to a predetermined length. In an example embodiment of the present invention, a plurality of fifth wirings 282 may be spaced apart from each other along the first direction D1. A plurality of sixth wirings 284 may be spaced apart from each other along the first direction D1.

The fifth and sixth vias 302 and 304 may extend through the seventh insulating interlayer 290 and contact upper surfaces of the fifth and sixth wirings 282 and 284, respectively.

In example embodiments of the present invention, a plurality of fifth vias 302 may be spaced apart from each other along the first and second directions D1 and D2 and form a fifth via array, and a plurality of sixth vias 304 may be spaced apart from each other along the first and second directions D1 and D2 and form a sixth via array.

In example embodiments of the present invention, a plurality of fifth vias 302 may be spaced apart from each other along the first direction D1 and may be disposed on the fifth wiring 282 extending along the first direction D1 and form a fifth via group. A plurality of fifth via groups may be spaced apart from each other along the first direction D1 and form a fifth via column. A distance measured along the first direction D1 between the fifth vias 302 included in each of the fifth via groups may be less than a distance measured along the first direction D1 between the fifth via groups.

The fifth via array may include a plurality of fifth via columns disposed along the second direction D2. The fifth via groups disposed along the second direction D2 may form a fifth via row, and the fifth via array may include a plurality of fifth via rows disposed along the first direction D1.

In example embodiments of the present invention, a plurality of sixth vias 304 may be spaced apart from each other along the first direction D1 and may be disposed on the sixth wiring 284 extending along the first direction D1 and form a sixth via group. A plurality of sixth via groups may be spaced apart from each other along the first direction D1 and form a sixth via column. A distance measured along the first direction D1 between the sixth vias 304 included in each of the sixth via groups may be less than a distance measured along the first direction D1 between the sixth via groups.

The sixth via array may include a plurality of sixth via columns disposed along the second direction D2. The sixth via groups disposed along the second direction D2 may form a sixth via row, and the sixth via array may include a plurality of sixth via rows disposed along the first direction D1.

The seventh and eighth wirings 312 and 314 may be formed on the seventh insulating interlayer 290, and the fifth and sixth vias 302 and 304 and contact upper surfaces of the fifth and sixth vias 302 and 304, respectively.

In example embodiments of the present invention, each of the seventh and eighth wirings 312 and 314 may have a shape of a right angled triangle including two sides extending along the first and second directions D1 and D2, respectively. A longer side (a hypotenuse of the right angled triangle) may extend along one of the third and fourth directions D3 and D4, in a plan view. The seventh and eighth wirings 312 and 314 may be spaced apart from each other and alternatively disposed along the first direction D1. FIG. 1 illustrates the longer side of the seventh wiring 312 extending along the fourth direction D4, and the longer side of the eighth wiring 314 extending along the third direction D3, however, the inventive concept may not be necessarily limited thereto.

In example embodiments of the present invention, the seventh wiring 312 may contact upper surfaces of ones of the fifth vias 302 included in the fifth via groups of the fifth via row, and the eighth wiring 314 may contact upper surfaces of ones of the sixth vias 302 included in the sixth via groups of the sixth via row.

In example embodiments of the present invention, a thickness of the seventh and eighth wirings 312 and 314 measured along the fifth direction D5 may be greater than the respective thicknesses of the first to sixth wirings 202, 204, 242, 244, 282 and 284 measured along the fifth direction D5.

The first to sixth vias 222, 224, 262, 264, 302 and 304 and the first to eighth wirings 202, 204, 242, 244, 282, 284, 312 and 314 may include a conductive material such as a metal, a metal nitride, a metal silicide, etc.

In example embodiments of the present invention, the fourth impurity region 108 might not overlap the seventh and eighth wirings 312 and 314 along the fifth direction D5. For example, the seventh and eighth wirings 312 and 314 may be spaced apart from each other along the first direction D1, and the fourth impurity region 108 may be formed on a portion of the substrate 100 on which the seventh and eighth wirings 312 and 314 are not formed, which may be the portions of the substrate 100 between neighboring gate structures 150 along the second direction D2.

In an example embodiment of the present invention, a sidewall extending along the second direction D2 of the fourth impurity region 108 may be aligned with a sidewall extending along the second direction D2 of a corresponding one of the seventh and eighth wirings 312 and 314 along the fifth direction D5.

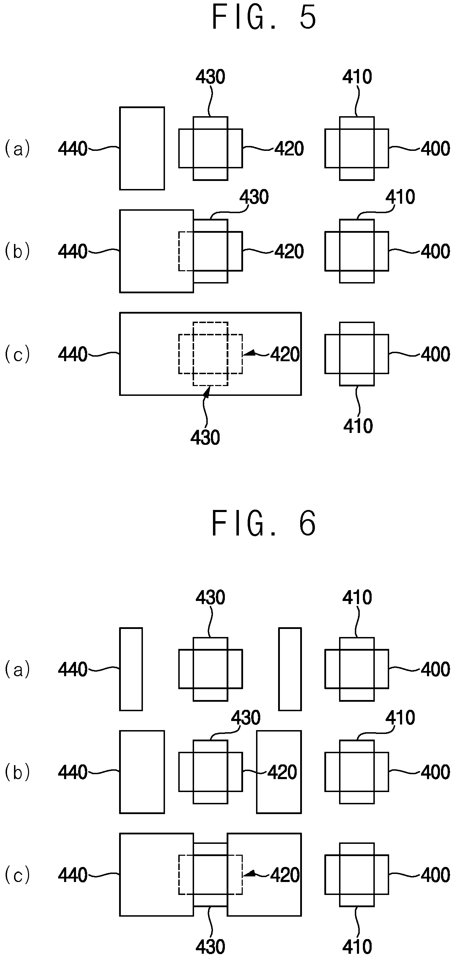

The transistor included in the semiconductor device may be a part of, for example, a power management integrated circuit (PMIC). A maximum current of about 2A to about 7A may flow in the PMIC, and during an operation of the PMIC, a portion of circuit pattern included in the PMIC may burn due to an overcurrent or a decrease of an on-current breakdown voltage (ON BV). The cause of this burning of the PMIC is described below with reference to FIGS. 5 to 9.

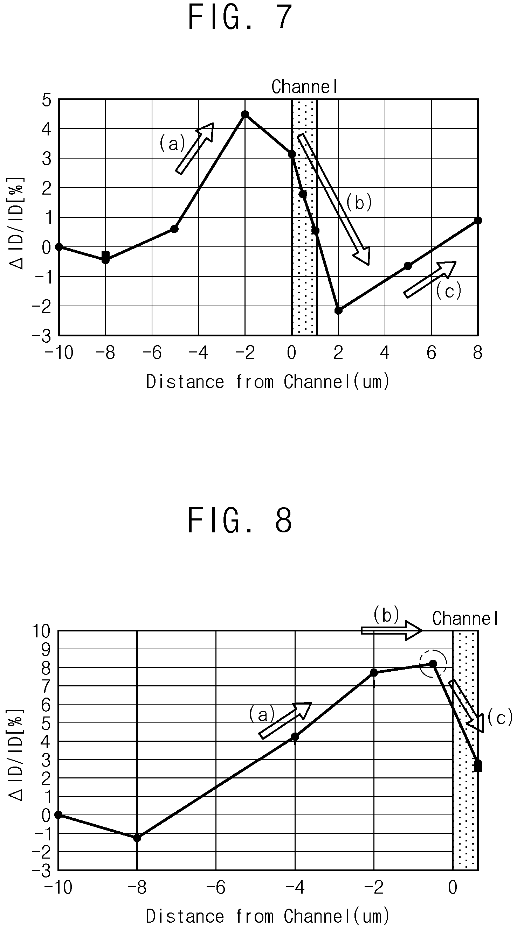

FIGS. 5 and 6 are plan views illustrating a relative position between the transistor and an upper wiring, and FIGS. 7 and 8 are graphs illustrating drain currents in the transistor.

FIGS. 5 and 6 illustrate a first channel 410 disposed at an upper portion of a first active pattern 400 on which a first transistor is formed and a second channel 430 disposed at an upper portion of a second active pattern 420 on which a second transistor is formed. An upper wiring might not be disposed over the first transistor and an upper wiring 440 may be disposed over the second transistor.

In FIG. 5, element (a), a horizontal distance between the upper wiring 440 and the second channel 430 may be about 2µm in a plan view, and in FIG. 5, element (b), a horizontal distance between the upper wiring 440 and the second channel 430 may be about 0µm in a plan view. In FIG. 5, element (c), the upper wiring 440 may entirely overlap the second transistor in the vertical direction, and a horizontal distance between an end of the upper wiring 440 to an end of the second channel 430 may be about 8µm.

In FIG. 6, the upper wirings 440 are disposed at opposite sides of the second transistor. In FIG. 6, element (a), a horizontal distance between each of the upper wirings 440 and the second channel 430 may be about 4 µm in a plan view, in FIG. 6, element (b), a horizontal distance between each of the upper wirings 440 and the second channel 430 may be about 2 µm in a plan view, and in FIG. 6, element (c), a horizontal distance between each of the upper wirings 440 and the second channel 430 may be about 0 µm in a plan view.

In FIGS. 7 and 8, a horizontal axis represents a horizontal distance from the second channel 430 to the upper wiring 440, and a vertical axis represents a ratio ΔI_{D}/I_{D} of a difference ΔI_{D} between a drain current in the first transistor and a drain current in the second transistor with respect to the drain current in the first transistor (hereinafter, referred to as a current ratio).

Referring to FIGS. 5 and 7, as the horizontal distance from the second channel 430 to the upper wiring 440 decreases, the current ratio increases and may have a maximum value at about 2µm. The current ratio may decrease until the upper wiring 440 and the second channel 430 overlaps by about 2 µm.

Referring to FIGS. 6 and 8, as the horizontal distance from the second channel 430 to the upper wiring 440 decreases, the current ratio increases and may have a maximum value of about 8.2% at about 0.5 µm. The current ratio may decrease until the horizontal distance from the second channel 430 to each of the upper wirings 440 is about 0 µm.

In the second transistor, where the upper wirings 440 is formed, a shorter horizontal distance between the upper wiring 440 and the second channel 403 compared to the horizontal distance between the upper wiring 440 and the first transistor may lead to a surge in current. The surge in current is attributed to the transfer of stress from the upper wiring 440 and insulation layers surrounding the upper wiring 440, which increases the mobility of the second channel 430.

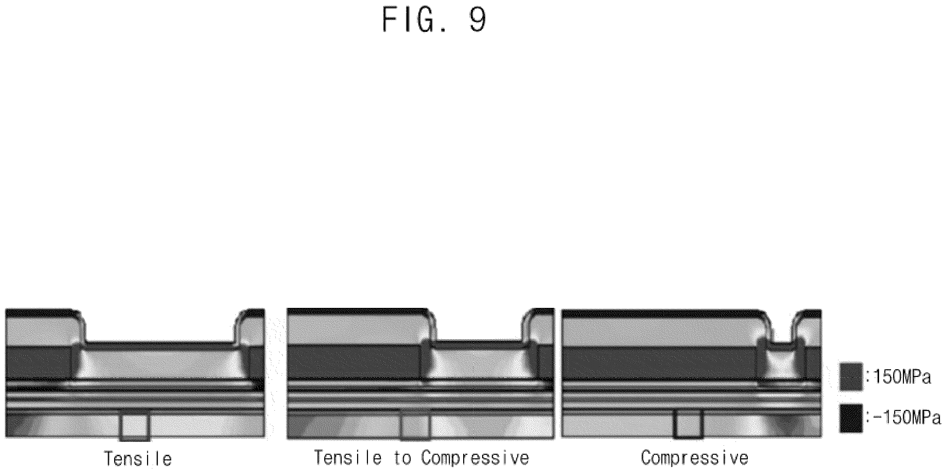

FIG. 9 is a simulation picture illustrating stress applied to the second channel included in the second transistor according to the relative position between the second transistor and the upper wiring.

Referring to FIG. 9, in FIG. 5, element (a), a tensile stress is applied to the second channel 430, in FIG. 5, element (b), the tensile stress applied to the second channel 430 changes to a compressive stress, in FIG. 5, element (c), a compressive stress is applied to the second channel 430.

For example, the type of the stress applied to the second channel 430 may be changed according as the relative position between the upper wiring 440 and the second channel 430 changes. For example, the horizontal distance between the upper wiring 440 and the second channel 430 may be in a given range, the tensile stress may be applied to a portion of the second channel 430 adjacent to the upper wiring 440 in the horizontal direction, and thus a mobility of the second channel 430 may increase and may cause an overcurrent.

In example embodiments of the present invention, the semiconductor device may include the fourth impurity region 108 doped with p-type impurities. The fourth impurity region 108 is disposed at the upper portion of the substrate 100, adjacent to the seventh and eighth wirings 312 and 314 along the horizontal direction, corresponding to the upper wiring 440 illustrated in FIGS. 5 and 6 which are disposed at the uppermost level among the wirings of the wiring structure.

The fourth impurity region 108 may include the impurities having an opposite conductivity type to that of the first and second source/drain regions 102 and 104. Thus, a current flowing in the channel of the transistor including the gate structure 150 and the first and second source/drain regions 102 and 104 may be reduced locally. Additionally, the fourth impurity region 108 may serve as a path through which holes generated by the current in the channel may exit. Accordingly, a portion of the channel between the fourth impurity region 108 and the second impurity region 104 may have an on-current breakdown voltage (ON BV) that is greater than that of other portions of the channel between the first and second impurity regions 102 and 104.

As a result, in the semiconductor device further including the fourth impurity region 108, a phenomenon in which a portion of the circuit pattern burns due to the generation of the overcurrent in the channel or the reduction of the ON BV of the transistor by the upper wirings may be prevented or reduced.

As the fourth impurity region 108 is formed, the current in the channel of the transistor may be locally reduced, however, the fourth impurity region 108 is formed at an extremely small portion of the first source/drain region 102. Thus, the total loss of current in the channel may be very small. If the fourth impurity region 108 is not formed, there may be a risk of overcurrent flowing through a portion of the channel that does not overlap with the seventh and eight wirings 312 and 314 along the fifth direction D5. Thus, the formation of the fourth impurity region 108 may maintain a uniform current flow in the channel.

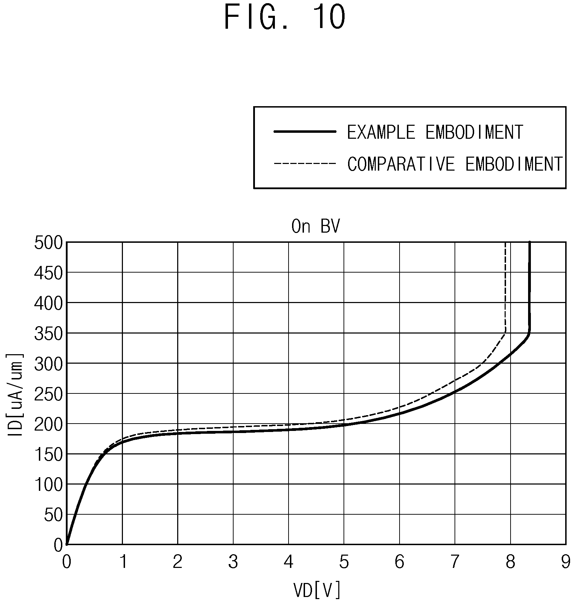

The local increase of the ON BV due to the fourth impurity region 108 is shown in FIG. 10.

FIG. 10 shows a graph illustrating ON BVs of a transistor in Comparative Embodiment and a transistor in Example Embodiment.

The transistor in Comparative Embodiment does not include the fourth impurity region 108, while the transistor in Example Embodiment includes the fourth impurity region 108.

Referring to FIG. 10, an ON BV of the transistor in Example Embodiment is greater than an ON BV of the transistor in Comparative Embodiment by about 0.5V.

In consideration of the above, when a layout of a circuit pattern is designed, the fourth impurity region 108 may be automatically disposed at a portion of the first source/drain region 102 which is not overlapping the upper wirings 312 and 314 along the fifth direction D5.

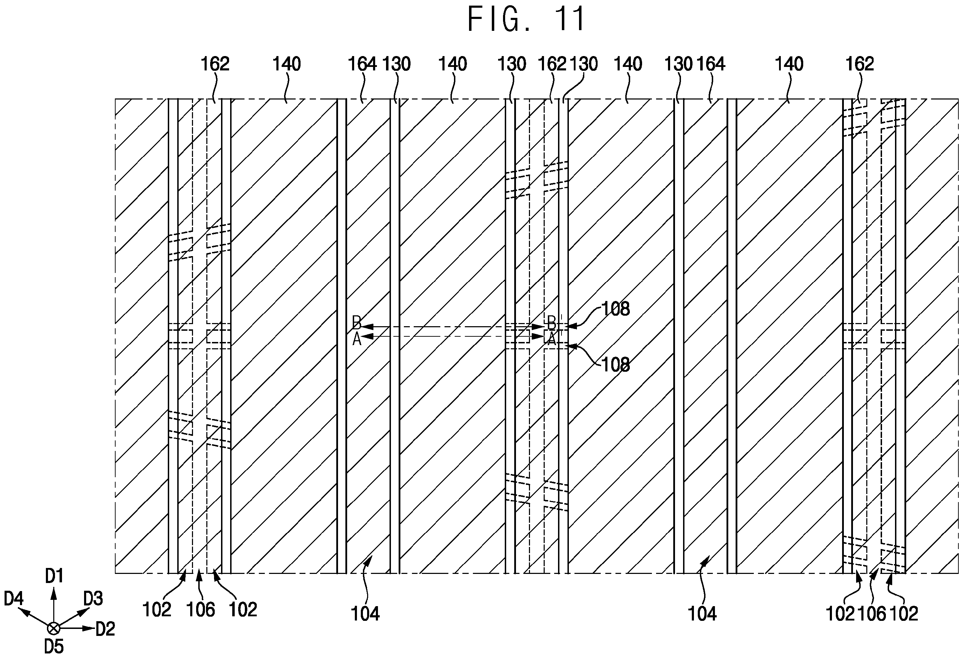

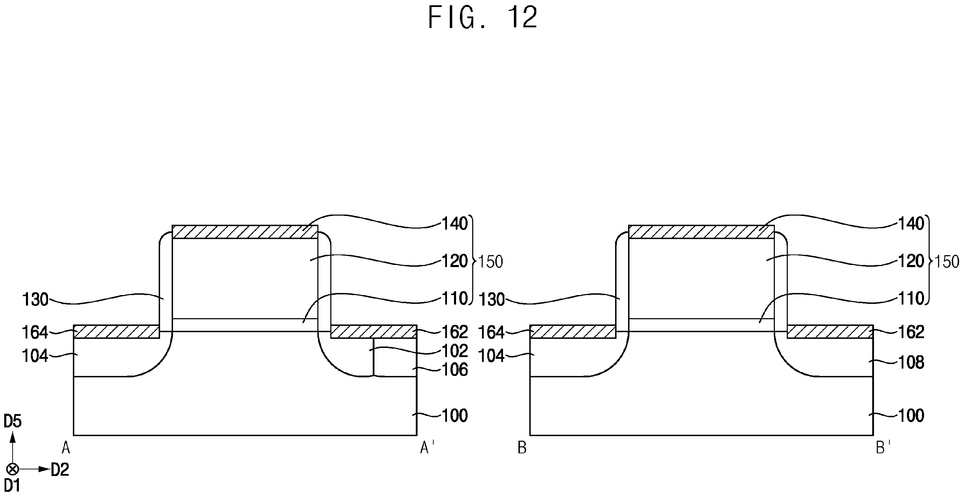

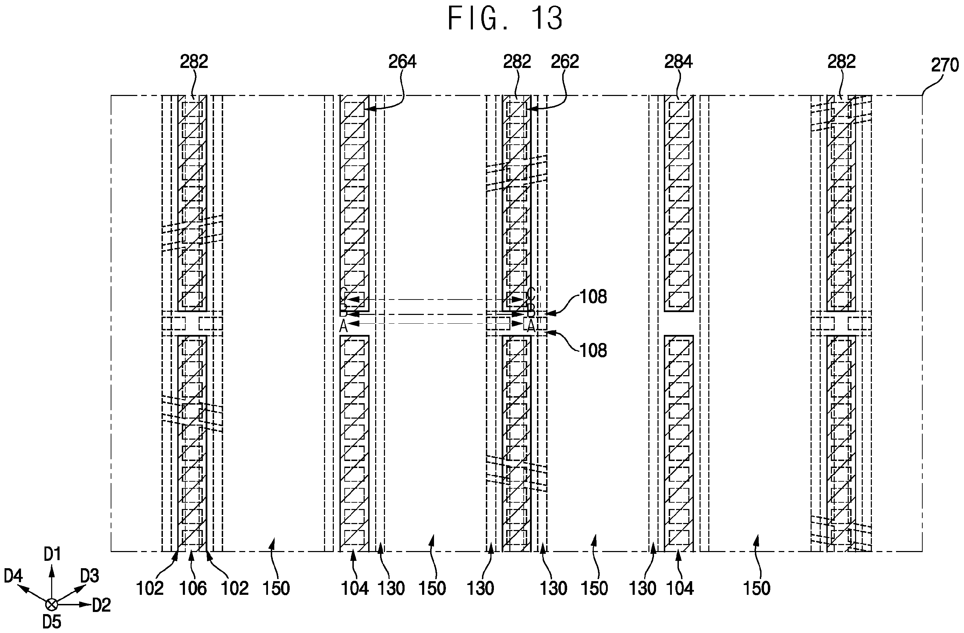

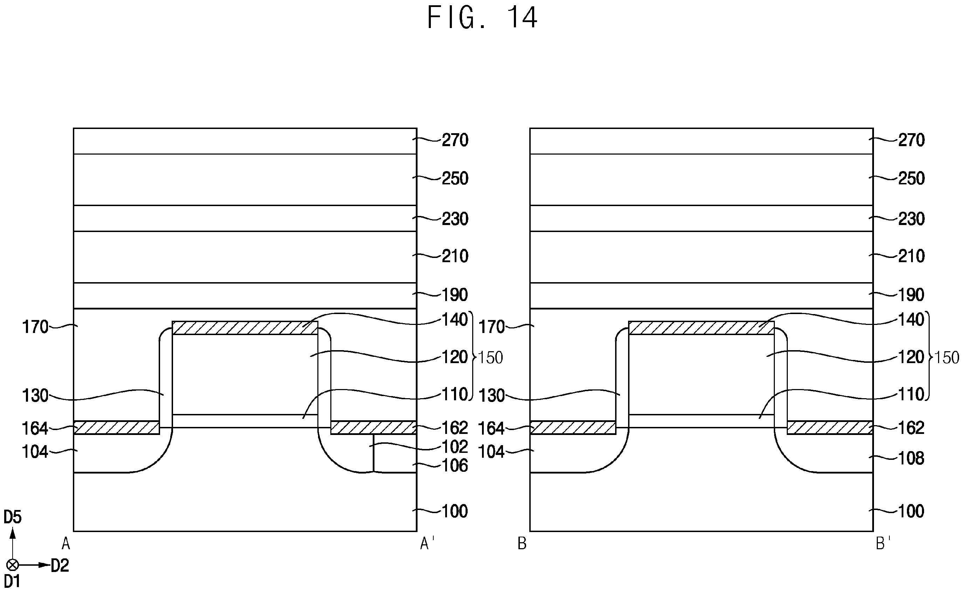

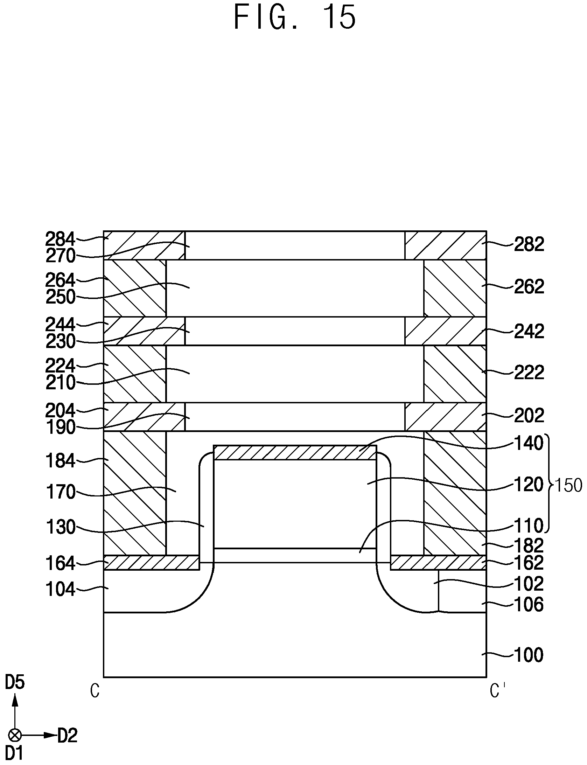

FIGS. 11 to 15 are plan views and cross-sectional views illustrating a method of manufacturing a semiconductor device in accordance with example embodiments of the present invention. FIGS. 11 and 13 are the plan views, each of FIGS. 12 and 14 includes cross-sectional views taken along lines A-A' and B-B', respectively, of corresponding plan views, and FIG. 15 is a cross-sectional view taken along line C-C' of a corresponding plan view.

Referring to FIGS. 11 and 12, a gate structure 150 and a gate spacer 130 may be formed on a substrate 100, and first to fourth impurity regions 102, 104, 106 and 108 may be formed at upper portions of the substrate 100 adjacent to the gate structure 150.

The gate structure 150, the gate spacer 130 and the first to fourth impurity regions 102, 104, 106 and 108 may be formed by following processes.

For example, a gate insulation layer and a gate electrode layer may be sequentially stacked on the substrate 100 and may be patterned to form a gate insulation pattern 110 and the gate electrode 120, respectively. In example embodiments of the present invention, each of the gate insulation pattern 110 and the gate electrode 120 may extend along the first direction D1. A plurality of gate insulation patterns 110 may be spaced apart from each other along the second direction D2, and a plurality of gate electrodes 120 may be spaced apart from each other along the second direction D2.

A gate spacer layer may be formed on the substrate 100 having the gate insulation pattern 110 and the gate electrode 120 thereon and may be anisotropically etched to form a gate spacer 130 on sidewalls in the second direction D2 of the gate insulation pattern 110 and the gate electrode 120.

A first mask may be formed on the substrate 100, and an ion implantation process may be performed using the first mask, the gate electrode 120 and the gate spacer 130 as an ion implantation mask to form the first to fourth impurity regions 102, 104, 106 and 108 at the upper portions of the substrate 100.

In example embodiments of the present invention, each of the first and second impurity regions 102 and 104 may extend along the first direction D1, and the first and second impurity regions 102 and 104 may be alternatively formed along the second direction D2. Each of the first and second impurity regions 102 and 104 may be formed at an upper portion of the substrate 100 between neighboring gate electrodes 120 along the second direction D2. The first and second impurity regions 102 and 104 may also be referred to as first and second source/drain regions 102 and 104, respectively, and may include n-type impurities such as phosphorous, arsenic, etc.

However, in example embodiments of the present invention, the third impurity region 106 may extend through the first impurity region 102 in the first direction D1, and thus the first source/drain region 102 may be divided into two parts by the third impurity region 106 along the second direction D2 between neighboring gate electrodes 120 along the second direction D2.

In example embodiments of the present invention, the fourth impurity region 108 may extend through the first source/drain region 102 and may extend along one of the second to fourth directions D2, D3 and D4 and may be disposed at an upper portion of the substrate 100 between neighboring gate electrodes 120 along the second direction D2. A plurality of fourth impurity regions 108 may be spaced apart from each other along the first direction D1.

Two fourth impurity regions 108, which are disposed adjacent to each other along the first direction D1 and extend along the same direction among the plurality of fourth impurity regions 108 may form an impurity region pair, and a plurality of impurity region pairs may be spaced apart from each other along the first direction D1.

Each of the fourth impurity regions 108 may be connected to the third impurity region 106 extending along the first direction D1. In example embodiments of the present invention, each of the third and fourth impurity regions 106 and 108 may include p-type impurities such as boron, aluminum, etc.

A metal layer may be formed on the gate electrode 120, the gate spacer 130 and the substrate 100, and a heat treatment process may be performed on the metal layer to form first to third metal silicide patterns 140, 162 and 164.

The first metal silicide pattern 140 may be formed on the gate electrode 120, the second metal silicide pattern 162 may be formed on the first source/drain region 102 and the third and fourth impurity regions 106 and 108, and the third metal silicide pattern 164 may be formed on the second source/drain region 104.

The gate insulation pattern 110, the gate electrode 120 and the first metal silicide pattern 140 sequentially stacked along the fifth direction D5 may collectively form a gate structure 150. The gate structure 150 may extend along the first direction D1, and a plurality of gate structures 150 may be spaced apart from each other along the second direction D2.

Referring to FIGS. 13 to 15, a first insulating interlayer 170 may be formed on the gate structure 150, the gate spacer 130 and the second and third metal silicide patterns 162 and 164. First and second contact plugs 182 and 184 may be formed through the first insulating interlayer 170 to contact upper surfaces of the second and third metal silicide patterns 162 and 164, respectively.

In example embodiments of the present invention, a plurality of first contact plugs 182 may be spaced apart from each other along the first direction D1 and may be disposed on the second metal silicide pattern 162 extending along the first direction D1. A plurality of second contact plugs 184 may be spaced apart from each other along the first direction D1 and may be disposed on the third metal silicide pattern 164 extending along the first direction D1.

A second insulating interlayer 190 may be formed on the first insulating interlayer 170 and the first and second contact plugs 182 and 184, and first and second wirings 202 and 204 may be formed through the second insulating interlayer 190 to contact upper surfaces of the first and second contact plugs 182 and 184, respectively.

Each of the first and second wirings 202 and 204 may extend along the first direction D1 to a predetermined length. In an example embodiment of the present invention, a plurality of first wirings 202 may be spaced apart from each other along the first direction D1, and a plurality of second wirings 204 may be spaced apart from each other along the first direction D1.

A third insulating interlayer 210 may be formed on the second insulating interlayer 190 and the first and second wirings 202 and 204, and first and second vias 222 and 224 may be formed through the third insulating interlayer 210 to contact upper surfaces of the first and second wirings 202 and 204, respectively.

In example embodiments of the present invention, a plurality of first vias 222 may be spaced apart from each other along the first direction D1 and may be disposed on the first wiring 202 extending along the first direction D1.

In example embodiments of the present invention, a plurality of first vias 222 may be spaced apart from each other along the first direction D1 and may be disposed on the first wiring 202 extending in the first wiring 202. A plurality of second vias 224 may be spaced apart from each other along the first direction D1 on the second wiring 204 extending along the first direction D1.

Following a process similar to the formation of the second and third insulating interlayers 190 and 210, the first and second wirings 202 and 204, and the first and second vias 222 and 224, fourth to sixth insulating interlayers 230, 250 and 270, third to sixth wirings 242, 244, 282 and 284, and third and fourth vias 262 and 264 may be formed on the third insulating interlayer 210 and the first and second vias 222 and 224.

Referring to FIGS. 1 to 4 again, a seventh insulating interlayer 290 may be formed on the sixth insulating interlayer 270 and the fifth and sixth wirings 282 and 284, and fifth and sixth vias 302 and 304 may be formed through the seventh insulating interlayer 290 to contact upper surfaces of the fifth and sixth wirings 282 and 284, respectively.

In example embodiments of the present invention, a plurality of fifth vias 302 may be spaced apart from each other along the first and second directions D1 and D2 to form a fifth via array. A plurality of sixth vias 304 may be spaced apart from each other along the first and second directions D1 and D2 to form a sixth via array.

Seventh and eighth wirings 312 and 314 may be formed on the seventh insulating interlayer 290 and the fifth and sixth vias 302 and 304 to contact upper surfaces of the fifth and sixth vias 302 and 304, respectively.

In example embodiments of the present invention, each of the seventh and eighth wirings 312 and 314 may have a shape of a right angled triangle, and the seventh and eighth wirings 312 and 314 may be spaced apart from each other and alternatively disposed along the first direction D1. A longer side of the seventh wiring 312 may extend along the third direction D3, and a longer side of the eighth wiring 314 may extend along the fourth direction D4.

An eighth insulating interlayer may be formed on the seventh insulating interlayer 290 to cover the seventh and eighth wirings 312 and 314, and a protective layer may be formed on the eighth insulating interlayer to complete the fabrication of the semiconductor device.

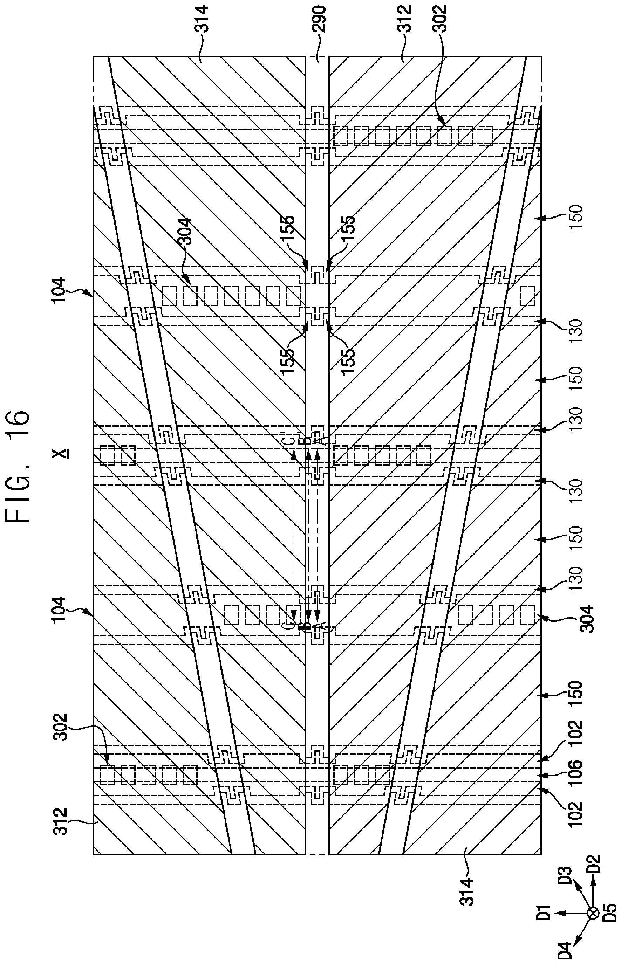

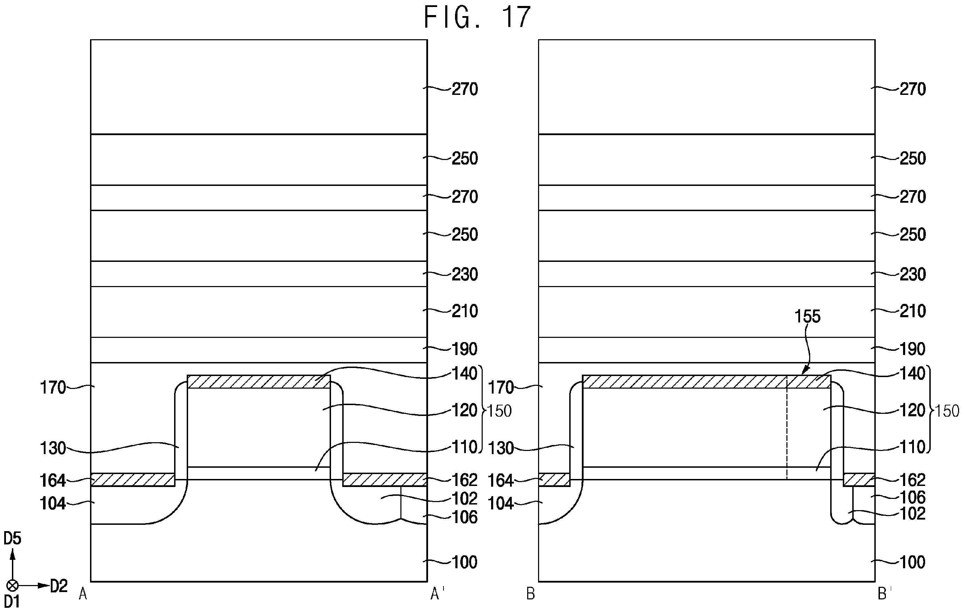

FIGS. 16 and 17 are a plan view and a cross-sectional view illustrating a semiconductor device in accordance with example embodiments of the present invention, which may correspond to FIGS. 2 and 3, respectively.

To the extent that an element has not been described in detail, it may be assumed that the element is at least similar to corresponding elements that have been described in FIGS. 1 to 4..

Referring to FIGS. 16 and 17, the semiconductor device might not include the fourth impurity region 108, however, the gate structure 150 may include a protrusion portion 155.

In example embodiments of the present invention, the protrusion portion 155 may protrude from a sidewall along the second direction D2 of a portion of the gate structure 150, which is not overlapping the seventh and eighth wirings 312 and 314 along the fifth direction D5, in one of the second to fourth directions D2, D3 and D4. Two protrusion portions on opposite sidewalls, disposed along the second direction D2 respectively, of the portion of the gate structure 150 may form a protrusion portion pair.

A plurality of protrusion pairs on the opposite sidewalls along the second direction D2 of the gate structures 150 may form a protrusion portion group. The protrusion portions 155 in the protrusion portion group, which may be opposite to each other along one of the second to fourth directions D2, D3 and D4, may be aligned with each other along the one of the second to fourth directions D2, D3 and D4.

In example embodiments of the present invention, a plurality of protrusion portion groups may be spaced apart from each other along the first direction D1 to form a protrusion portion array.

As the gate structure 150 includes the protrusion portion 155, a current flowing in the channel under the portion of the gate structure 150 not overlapping the seventh and eighth wirings 312 and 314 along the fifth direction D5 may be locally reduced, and holes generated by the current in the channel may be reduced to cause an increase of the ON BV.

Embodiments are set out in the following clauses:
Clause 1. A semiconductor device, comprising:
   a gate structure disposed on a substrate and extending along a first direction that is substantially parallel to an upper surface of the substrate;
   first and second impurity regions disposed on portions of the substrate at opposite sides of the gate structure along a second direction that is substantially parallel to the upper surface of the substrate, the first and second impurity regions being substantially perpendicular to each other, wherein the first and second impurity regions are each doped with n-type impurities;
   a third impurity region disposed on a portion of the substrate adjacent to the first impurity region along the second direction, wherein the third impurity region is doped with p-type impurities;
   a fourth impurity region disposed on a portion of the substrate adjacent to the first impurity region along the first direction, wherein the fourth impurity region is connected to the third impurity region and is doped with p-type impurities; and
   a wiring structure disposed on the gate structure, wherein the wiring structure includes wirings that are disposed on a plurality of different levels,
   wherein the fourth impurity region does not overlap a first one of the wirings along a vertical direction that is substantially perpendicular to the upper surface of the substrate, and
   wherein the first one of the wirings is disposed at an uppermost level among the plurality of different levels.
Clause 2. The semiconductor device according to clause 1, further comprising a plurality of fourth impurity regions spaced apart from each other along the first direction, wherein the fourth impurity region is one of the plurality of fourth impurity regions.
Clause 3. The semiconductor device according to clause 2,
   wherein the plurality of fourth impurity regions include a plurality of impurity region pairs,
   wherein each of the plurality of impurity region pairs includes two fourth impurity regions among the plurality of fourth impurity regions, and
   wherein the two fourth impurity regions are disposed adjacent to and spaced apart from each other along the first direction.
Clause 4. The semiconductor device according to clause 3,
   wherein the impurity region pairs include a first impurity region pair, a second impurity region pair and a third impurity region pair,
   wherein the first impurity region pair includes two fourth impurity regions extending along the second direction,
   wherein the second impurity region pair includes two fourth impurity regions extending along a third direction that is substantially parallel to the upper surface of the substrate and has an acute angle with respect to the first and second directions, and
   wherein the third impurity region pair includes two fourth impurity regions extending along a fourth direction that is substantially parallel to the upper surface of the substrate, has an acute angle with respect to the first and second directions, and is different from the third direction.
Clause 5. The semiconductor device according to clause 4, wherein the first impurity region pair, the second impurity region pair, the first impurity region pair and the third impurity region pair are arranged in this order.
Clause 6. The semiconductor device according to any preceding clause, further comprising a plurality of first ones of the wirings which are spaced apart from each other along the first direction,
   wherein the third impurity region extends along the first direction,
   wherein the semiconductor device further comprises a plurality of fourth impurity regions spaced apart from each other in the first direction,
   wherein the fourth impurity region is one of the plurality of fourth impurity regions, and
   wherein the plurality of fourth impurity regions does not overlap the plurality of first ones of the wirings along the vertical direction.
Clause 7. The semiconductor device according to clause 6, wherein each of the plurality of first ones of the wirings has a shape of a right triangle in a plan view, including two sides extending along the first and second directions, and a side extending along a third direction or a fourth direction that is substantially parallel to the upper surface of the substrate and has an acute angle with respect to the first and second directions, and
   wherein each of the plurality of fourth impurity regions extends along one of the second to fourth directions.
Clause 8. The semiconductor device according to clause 7, wherein the plurality of first ones of the wirings include first and second wirings alternatively arranged along the first direction, and
   wherein the semiconductor device further comprises:
   a first via electrically connected to the third impurity region and contacting a lower surface of the first wiring; and
   a second via electrically connected to the second impurity region and contacting a lower surface of the second wiring.
Clause 9. The semiconductor device according to clause 8, further comprising a plurality of first vias spaced apart from each other along the first direction and a plurality of second vias spaced apart from each other along the first direction,
   wherein the first via is one of the plurality of first vias, and the second via is one of the plurality of second vias.
Clause 10. The semiconductor device according to any preceding clause, wherein a sidewall of the fourth impurity region is aligned with a sidewall of the first one of the wirings along the vertical direction.
Clause 11. A semiconductor device, comprising:
   a gate structure disposed on a substrate, wherein the gate structure extends along a first direction substantially parallel to an upper surface of the substrate;
   first and second impurity regions disposed on portions of the substrate at opposite sides of the gate structure along a second direction substantially parallel to the upper surface of the substrate, and the first and second impurity regions being substantially perpendicular to each other; and
   a wiring structure disposed on the gate structure, wherein the wiring structure includes wirings at a plurality of different levels,
   wherein the gate structure includes a protrusion portion that protrudes along the second direction from a sidewall of the gate structure along the second direction,
   wherein the protrusion portion of the gate structure does not overlap a first one of the wirings along a vertical direction substantially perpendicular to the upper surface of the substrate, and
   wherein the first one of the wirings are disposed at an uppermost level among the plurality of different levels.
Clause 12. The semiconductor device according to clause 11, wherein the gate structure includes a plurality of protrusion portions spaced apart from each other along the first direction.
Clause 13. The semiconductor device according to clause 12, wherein the plurality of protrusion portions include a plurality of protrusion portion pairs spaced apart from each other along the first direction, and
   wherein each of the plurality of protrusion portion pairs includes two protrusion portions among the plurality of protrusion portions that is disposed adjacent to each other along the first direction.
Clause 14. The semiconductor device according to any of clauses 11-13, wherein the gate structure includes two protrusion portions on opposite sidewalls of the gate structures along the second direction.
Clause 15. The semiconductor device according to clause 14, further comprising a plurality of gate structures spaced apart from each other along the second direction,
   wherein the protrusion portions on sidewalls of neighboring ones of the plurality of gate structures along the second direction are aligned with each other along the second direction.
Clause 16. A semiconductor device, comprising:
   gate structures disposed on a substrate,
   wherein each of the gate structures extends along a first direction substantially parallel to an upper surface of the substrate, and
   wherein the gate structures are spaced apart from each other along a second direction substantially parallel to the upper surface of the substrate and substantially perpendicular to the first direction;
   first and second impurity regions disposed on opposite portions of the substrate with respect to the gate structure, wherein each of the first and second impurity regions extends along the first direction and is doped with n-type impurities;
   a third impurity region extending through the first impurity region to divide the first impurity region into two parts along the second direction, wherein the third impurity region is doped with p-type impurities;
   a fourth impurity region extending through the first impurity region along the first direction, wherein the fourth impurity region is connected to the third impurity region and is doped with p-type impurities;
   a first metal silicide pattern disposed on the first, third and fourth impurity regions;
   a second metal silicide pattern disposed on the second impurity region; and
   a wiring structure disposed on the first and second metal silicide patterns, wherein the wiring structure includes wirings at a plurality of different levels and is electrically connected to the first and second metal silicide patterns,
   wherein the fourth impurity region does not overlap a first one of the wirings along a vertical direction substantially perpendicular to the upper surface of the substrate, and
   wherein the first one of the wirings is disposed at an uppermost level among the plurality of different levels.
Clause 17. The semiconductor device according to clause 18, wherein the wirings further include a second one of the wirings, wherein the second one of the wirings is disposed at an uppermost level among the plurality of different levels and is spaced apart from the first one of the wirings,
   wherein the semiconductor device further comprises a plurality of fourth impurity regions spaced apart from each other along the first direction,
   wherein the fourth impurity region is one of the plurality of fourth impurity regions, and
   wherein each of the plurality of fourth impurity regions is disposed between the first one and the second one in a plan view.
Clause 18. The semiconductor device according to clause 17, wherein each of the first one and the second one of the wirings has a shape of a right triangle in a plan view, including two sides extending along the first and second directions and a side extending along a third direction or a fourth direction that is substantially parallel to the upper surface of the substrate and has an acute angle with respect to the first and second directions, and wherein each of the plurality of fourth impurity regions extends along one of the second to fourth directions.
Clause 19. The semiconductor device according to any clause 17 or clause 18, further comprising:
   first vias electrically connected to the third impurity region and contacting a lower surface of the first wiring; and
   second vias electrically connected to the second impurity region and contacting a lower surface of the second wiring.
Clause 20. The semiconductor device according to any of clauses 16-19, wherein a sidewall of the fourth impurity region is aligned with a sidewall of the first one of the wirings along the vertical direction.

The foregoing is illustrative of example embodiments and should not necessarily be construed as limiting thereof. Although a few example embodiments have been described, those skilled in the art will readily appreciate that many modifications are possible in the example embodiments without materially departing from the novel teachings and advantages of the present inventive concept. Accordingly, all such modifications are intended to be included within the scope of the present inventive concept.

## Claims

1. A semiconductor device, comprising:
a gate structure disposed on a substrate and extending along a first direction that is substantially parallel to an upper surface of the substrate;
first and second impurity regions disposed on portions of the substrate at opposite sides of the gate structure along a second direction that is substantially parallel to the upper surface of the substrate, the first and second directions being substantially perpendicular to each other, wherein the first and second impurity regions are each doped with n-type impurities;
a third impurity region disposed on a portion of the substrate adjacent to the first impurity region along the second direction, wherein the third impurity region is doped with p-type impurities;
a fourth impurity region disposed on a portion of the substrate adjacent to the first impurity region along the first direction, wherein the fourth impurity region is connected to the third impurity region and is doped with p-type impurities; and
a wiring structure disposed on the gate structure, wherein the wiring structure includes wirings that are disposed on a plurality of different levels,
wherein the fourth impurity region does not overlap a first one of the wirings along a vertical direction that is substantially perpendicular to the upper surface of the substrate, and
wherein the first one of the wirings is disposed at an uppermost level among the plurality of different levels.

2. The semiconductor device according to claim 1, further comprising a plurality of fourth impurity regions spaced apart from each other along the first direction, wherein the fourth impurity region is one of the plurality of fourth impurity regions.

3. The semiconductor device according to claim 2,
wherein the plurality of fourth impurity regions include a plurality of impurity region pairs,
wherein each of the plurality of impurity region pairs includes two fourth impurity regions among the plurality of fourth impurity regions, and
wherein the two fourth impurity regions are disposed adjacent to and spaced apart from each other along the first direction.

4. The semiconductor device according to claim 3,
wherein the impurity region pairs include a first impurity region pair, a second impurity region pair and a third impurity region pair,
wherein the first impurity region pair includes two fourth impurity regions extending along the second direction,
wherein the second impurity region pair includes two fourth impurity regions extending along a third direction that is substantially parallel to the upper surface of the substrate and has an acute angle with respect to the first and second directions, and
wherein the third impurity region pair includes two fourth impurity regions extending along a fourth direction that is substantially parallel to the upper surface of the substrate, has an acute angle with respect to the first and second directions, and is different from the third direction.

5. The semiconductor device according to claim 4, the impurity region pairs further include a further first impurity region pair that includes two fourth impurity regions extending along the second direction, wherein the first impurity region pair, the second impurity region pair, the further first impurity region pair and the third impurity region pair are arranged in this order.

6. The semiconductor device according to any preceding claim, further comprising a plurality of first ones of the wirings which are spaced apart from each other along the first direction,
wherein the third impurity region extends along the first direction,
wherein the semiconductor device further comprises a plurality of fourth impurity regions spaced apart from each other in the first direction,
wherein the fourth impurity region is one of the plurality of fourth impurity regions, and
wherein the plurality of fourth impurity regions does not overlap the plurality of first ones of the wirings along the vertical direction.

7. The semiconductor device according to claim 6, wherein each of the plurality of first ones of the wirings has a shape of a right angled triangle in a plan view, including two sides extending along the first and second directions, and a side extending along a third direction or a fourth direction that is substantially parallel to the upper surface of the substrate and has an acute angle with respect to the first and second directions, and
wherein each of the plurality of fourth impurity regions extends along one of the second to fourth directions.

8. The semiconductor device according to claim 7, wherein the plurality of first ones of the wirings include first and second wirings alternatively arranged along the first direction, and
wherein the semiconductor device further comprises:
a first via electrically connected to the third impurity region and contacting a lower surface of the first wiring; and
a second via electrically connected to the second impurity region and contacting a lower surface of the second wiring.

9. The semiconductor device according to claim 8, further comprising a plurality of first vias spaced apart from each other along the first direction and a plurality of second vias spaced apart from each other along the first direction,
wherein the first via is one of the plurality of first vias, and the second via is one of the plurality of second vias.

10. The semiconductor device according to any preceding claim, wherein a sidewall of the fourth impurity region is aligned with a sidewall of the first one of the wirings along the vertical direction.

11. A semiconductor device, comprising:
a gate structure disposed on a substrate, wherein the gate structure extends along a first direction substantially parallel to an upper surface of the substrate;
first and second impurity regions disposed on portions of the substrate at opposite sides of the gate structure along a second direction substantially parallel to the upper surface of the substrate, and the first and second directions being substantially perpendicular to each other; and
a wiring structure disposed on the gate structure, wherein the wiring structure includes wirings at a plurality of different levels,
wherein the gate structure includes a protrusion portion that protrudes along the second direction from a sidewall of the gate structure along the second direction,
wherein the protrusion portion of the gate structure does not overlap a first one of the wirings along a vertical direction substantially perpendicular to the upper surface of the substrate, and
wherein the first one of the wirings is disposed at an uppermost level among the plurality of different levels.

12. The semiconductor device according to claim 11, wherein the gate structure includes a plurality of protrusion portions spaced apart from each other along the first direction.

13. The semiconductor device according to claim 12, wherein the plurality of protrusion portions include a plurality of protrusion portion pairs spaced apart from each other along the first direction, and
wherein each of the plurality of protrusion portion pairs includes two protrusion portions among the plurality of protrusion portions that are disposed adjacent to each other along the second direction.

14. The semiconductor device according to any of claims 11-13, wherein the gate structure includes two protrusion portions on opposite sidewalls of the gate structures along the second direction.

15. The semiconductor device according to claim 14, further comprising a plurality of gate structures spaced apart from each other along the second direction,
wherein the protrusion portions on sidewalls of neighboring ones of the plurality of gate structures along the second direction are aligned with each other along the second direction.
